# EUROPEAN PATENT APPLICATION

(11) **EP 3 863 388 A1**
(43) Date of publication of application: **11.08.2021**
(21) Application number: 18936098.5
(22) Date of filing: 05.10.2018
(51) Int. Cl.: H05K 5/06, H01L 25/07, H01L 25/10, H01L 25/18

(54) **SEMICONDUCTOR PACKAGE**

(71) Applicant: KABUSHIKI KAISHA TOSHIBA, Minato-ku Tokyo 105-8001 (JP); Toshiba Energy Systems & Solutions Corporation, Saiwai-ku Kawasaki-shi Kanagawa 2120013 (JP)
(72) Inventor: ITO, Hiroaki, Kawasaki-shi, Kanagawa 212-0013 (JP); ICHIKURA, Yuta, Kawasaki-shi, Kanagawa 212-0013 (JP); WATANABE, Naotake, Kawasaki-shi, Kanagawa 212-0013 (JP); TADA, Nobumitsu, Kawasaki-shi, Kanagawa 212-0013 (JP); TASHIRO, Shota, Kawasaki-shi, Kanagawa 212-0013 (JP); MIZUTANI, Mami, Kawasaki-shi, Kanagawa 212-0013 (JP); SEKIYA, Hiroki, Kawasaki-shi, Kanagawa 212-0013 (JP); HISAZATO, Yuuji, Kawasaki-shi, Kanagawa 212-0013 (JP); IIO, Naotaka, Kawasaki-shi, Kanagawa 212-0013 (JP)
(74) Representative: AWA Sweden AB
(86) International application number: PCT/JP2018/037492
(87) International publication number: WO 2020/070899

(57) **Abstract**

A semiconductor package that can suppress the rupture of the exterior even when the short-circuit failure occurs in a part of the semiconductor chips therein is provided. The semiconductor package includes a cooler (3) which is made of metal and which fixes a submodule (1), an outer circumferential side wall (4) which is made of resin and which is fixed to the cooler (3), and an upper plate which is made of metal and which is fixed to the outer circumferential side wall (4). The cooler (3) and the outer circumferential side wall (4) is fastened by a fastening member (6a), and the upper plate and the outer circumferential side wall (4) is fastened by a fastening member (6b). If the pressure in the submodule rapidly rises, the entire upper plate (5) is largely bent and deforms to prevent the destruction of the semiconductor package by the internal pressure rise.

## Description

### FIELD

Embodiments of the present disclosure relate to a semiconductor package.

### BACKGROUND

In a semiconductor device which handles high voltage of several kilovolts (kV) and large current of several kiloampere (kA), it is required to suppress an increase in temperature during operation as low as possible, and a plurality of switching elements may be connected in parallel for operation.

For this operation, there is a semiconductor package in which a plurality of submodules consisting of at least one switching element is connected in parallel to form a single package. This semiconductor package is required to ensure high reliability while achieving low heat resistance.

### PRIOR ART DOCUMENT

### PATENT DOCUMENT

Patent Document 1: Japanese Patent No. 3258200
Patent Document 2: Japanese Patent No. 4385324

### SUMMARY OF INVENTION

### PROBLEMS TO BE SOLVED BY INVENTION

In the above described submodule included in the semiconductor device, a semiconductor chip is sealed by resin. If short-circuit failure occurs in the semiconductor chips for some reasons, large current flow into the semiconductor chip, and the semiconductor chip may rupture. In this case, a large rupture occurs at the resin sealing the semiconductor chip due to melting and gasification of components in the submodule, and content thereof burst out from the rupture at high pressure.

In the semiconductor package, a space in which the submodule is arranged is a sealed space. If the content bursts out from the rupture at high pressure, the pressure in the sealed space rapidly rises, and there is a concern that the exterior of the semiconductor package may rupture.

The rupture of the exterior due to the short-circuit failure of the semiconductor chip not only causes the outflow of the bursted-out content of the submodule to the outside of the semiconductor package, but is also not preferable from the aspect of safety and operation continuity.

A semiconductor package of the present embodiment provides a semiconductor package that can suppress the rupture of the exterior even when the short-circuit failure occurs in a part of the semiconductor chip therein.

### MEANS TO SOLVE THE PROBLEM

A semiconductor package according to an embodiment including therein a plurality of submodules which has semiconductor chips therein and which is electrically connected in parallel, the semiconductor package including:
an electrode post which is in pair with the submodule and which supports the submodule;
a pedestal which is made of metal flat plate and which fixes the electrode post on one of surfaces thereof;
an outer circumferential side wall which is made of resin, which stands up from the pedestal and which surrounds a circumference of the plurality of the submodules;
an upper plate which is made of metal and which blocks an opening formed by the outer circumferential side wall;
a first fastening member which fixes the pedestal and the outer circumferential side wall by fastening; and
a second fastening member which fixes the upper plate and the outer circumferential side wall by fastening,
wherein the pedestal, the outer circumferential side wall, and the upper plate seals a space which includes therein the plurality of the submodules.

### BRIEF DESCRIPTION OF DRAWINGS

Fig. 1 is a cross sectional diagram illustrating a configuration of a semiconductor package according to a first embodiment.
Fig. 2 is a perspective view illustrating a configuration of a submodule according to a first embodiment.
Fig. 3 is a top view of an interior of a semiconductor package according to a first embodiment.
Fig. 4 is a cross sectional diagram illustrating a configuration of a semiconductor package according to a first embodiment.
Fig. 5 is a cross sectional diagram of a submodule illustrating a state in which content thereof bursted out.
Fig. 6 is a diagram illustrating a relationship between a pressure which content bursted out from an opened surface applies to an outer circumferential side wall, and a distance.
Fig. 7 is a cross sectional diagram of a semiconductor package illustrating a relationship between a thickness of an upper plate and stress when pressure is applied to an interior of a semiconductor package 100.
Fig. 8 is a diagram illustrating a relationship between a distance between a ruptured submodule and an outer circumferential side wall, and a stress applied to an outer circumferential side wall.
Fig. 9 is a cross sectional diagram of a semiconductor package according to a second embodiment.
Fig. 10 is a cross sectional diagram of a semiconductor package according to a second embodiment.
Fig. 11 is a cross sectional diagram of a semiconductor package according to a third embodiment.
Fig. 12 is a cross sectional diagram of a semiconductor package according to another embodiment.

### DESCRIPTION OF PREFERRED EMBODIMENT

In below, embodiments will be described with the reference to figures. Same portions in figures are labeled with same number, detailed descriptions thereof are omitted as appropriate, and different portions are described. Note that figures are schematic or conceptual, and a relationship of thicknesses and widths of each portion, a ratio of size between each portion, etc., are not necessarily the same as actual portions. Furthermore, even when same portions are represented, dimension and ratio thereof may be illustrated differently depending on figures. In addition, cross sectional diagrams may be intentionally illustrated in partially simplified form instead of accurate diagrams for convenience.

### [1. First Embodiment]

### [1-1. Configuration]

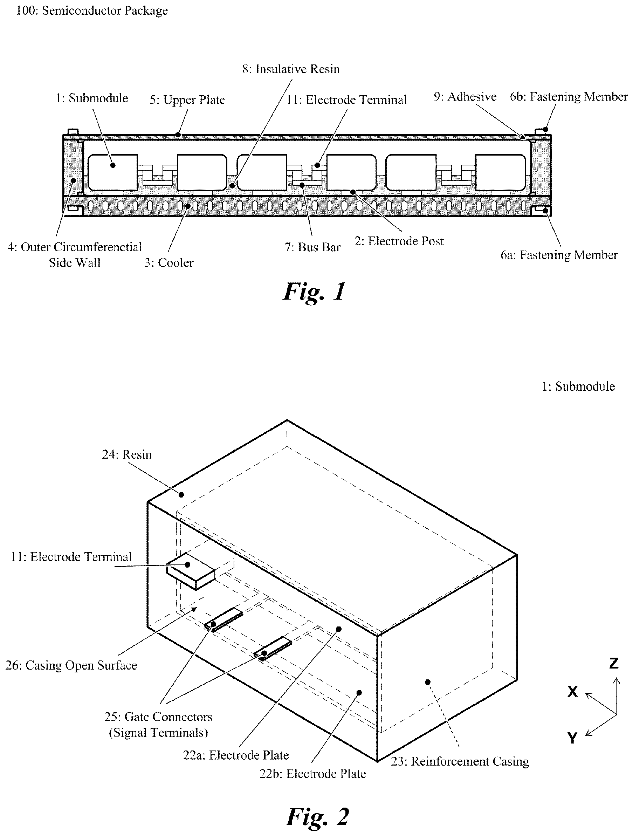

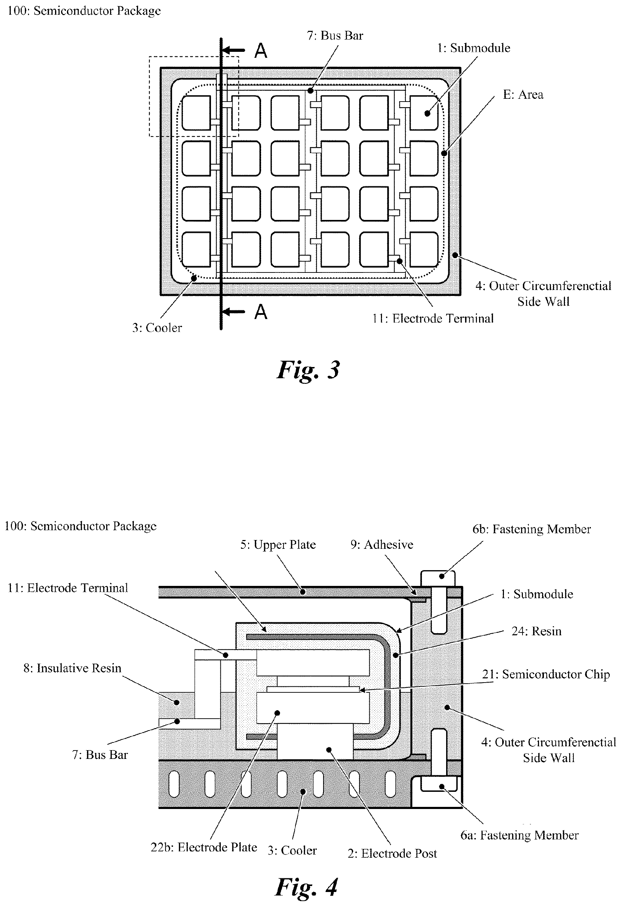

Fig. 1 is a cross sectional diagram illustrating a configuration of a semiconductor package according to a first embodiment. Fig. 2 is a perspective view illustrating a configuration of a submodule according to the first embodiment. Fig. 3 is a top view of an interior of the semiconductor package according to the first embodiment.

As illustrated in Fig. 1, a plurality of submodules 1 having semiconductor chips is arranged inside a semiconductor package 100. The submodules 1 are electrically connected in parallel to form single semiconductor package 100. The semiconductor package 100 includes an electrode post 2, a cooler 3 that is a pedestal, an outer circumferential side wall 4, and an upper plate 5. The cooler 3, the outer circumferential side wall 4, and the upper plate are fixed by a fastening member 6 to seal a space in which the submodules 1 are arranged. The submodules 1 are electrically connected by electrode terminals 11 via a bus bar 7.

The submodule 1 contains a semiconductor 21 therein. For example, the semiconductor 21 includes a power semiconductor element that is used to cover electric power. For example, such a power semiconductor element is a switching element having control electrode such as IGBT (Insulated Gate Bipolar Transistor) and MOFSET (Metal Oxide Semiconductor Field Effect Transistor), or a diode such as FRD (Fast Recovery Diode). A chip of the switching element and a chip of the diode may be mixed in one submodule 1.

As illustrated In Fig. 2, electrode plates 22 are joined to both surfaces of the electrode chip 22, the electrode plates 22 are housed inside a reinforcement casing 23 made of metal, and the entire body is sealed by resin 24. The submodule 1 has the electrode terminal 11 to connect to the bus bar 7 as an energizing path. The electrode terminal 11 is connected to one of two electrode plates 22 (hereinafter, referred to as an electrode plate 22a) . Furthermore, when the switching element is the semiconductor chip 21, a gate connector 25 protrudes to transmit signal to the semiconductor chips 21.

On surface of the submodule is a casing open surface 26 of the reinforcement casing 23. The electrode terminal 11 and the gate connector 25 extends and protrudes from the casing open surface 26 to an exterior of the submodule 1.

Fig. 3 is a schematic diagram of an internal layout of the semiconductor package viewed from above. As illustrated in Fig. 3, a number of the submodules 1 are electrically connected in parallel via the bus bar 7 in the semiconductor package 100.

The bus bar 7 electrically connects the electrode terminals 11 of the submodules 1 in the semiconductor package 100. The bus bar 7 includes a main shaft arranged between two submodules 1 such that the casing open surfaces 26 faces with each other, and a connection shaft which connects the main shafts. A number of submodules 1 are arranged collectively in one area (area E in Fig. 3) covered by the outer circumferential side wall 4.

Furthermore, the submodules 1 are arranged in the direction in which inclusions that are shelters would be arranged between the casing open surface 26 and the outer circumferential side wall 4 of the submodules 1. In Fig. 3, the inclusions are other submodules 1. Since the casing open surface 26 of each submodule 1 are arranged to face each other, other submodules 1 are present between the casing open surface 26 and the outer circumferential side wall 4 for all submodules 1.

Returning to Fig. 1, the cooler 3 is made of metal materials having high electrical conductivity and high thermal conductivity. Furthermore, since the cooler 3 is made of metal, the cooler 3 has rigidity and ductility higher than general resin materials. The cooler 3 includes iron, stainless steel, copper, or aluminum as the main component.

The cooler 3 is a flat plate member, and a plurality of the electrode post 2 is fixed on one surface of the flat plate. The electrode post 2 is a columnar member made of materials having high electrical conductivity and high thermal conductivity. One end of the electrode post 2 is fixed to the cooler 3, and the other end of the electrode post 2 is embedded in the submodule 1. Note that the electrode post 2 may be integral with the cooler 3. In the submodule 1, the electrode post 2 is electrically connected to a surface of the semiconductor chips 21 and contacts with the electrode plate 22 to which the electrode terminal 11 is not connected (hereinafter, referred to as an electrode plate 22b). That is, the cooler 3 is mechanically and electrically joined with the submodule 1 via the electrode post 2 and functions as a heat dissipator to dissipate heat generated in the submodule 1 and an electrode of the semiconductor chips 21.

The thickness of the cooler 3 is a thickness that can form an air gap therein. Coolant such as pure water may be circulated in the air gap inside the cooler 3 to dissipate heat from the cooler 3. Cooling fin may be provided to a surface opposite the surface to which the electrode post 2 of the cooler 3 is fixed. The cooling fin is provided to enlarge the heat transfer area and improve the heat dissipation efficiency.

Furthermore, an insulative resin 8 is filled in the surface to which the electrode post 2 of the cooler 3 is fixed. The insulative resin 8 is filled in between the cooler 3 and the bus bar 7, and insulates the cooler 3 and the bus bar 7.

The outer circumferential side wall 4 is a resin material that stands up from the surface to which the electrode post 2 of the cooler 3 is fixed. The outer circumferential side wall 4 is in a shape that covers without gaps the surrounding of the area E where the plurality of the submodules 1 is arranged. The outer circumferential side wall 4 is fastened to the cooler 3 by a fastening member 6a such as bolt. The fastening member 6a that fastens the outer circumferential side wall 4 and the cooler 3 is a first fastening member in claims.

Fig. 4 is a cross sectional diagram illustrating the configuration of the semiconductor package according to the first embodiment. As illustrated in Fig. 4, a notch is provided to a part of the outer circumferential side wall 4, and a sealing adhesive 9 is adhered circumferentially around the notch. By cutting out a part of the contact surface between the outer circumferential side wall 4 and the cooler 3, a step which has the height different with the contact surface can be created to form the notch. Since the outer circumferential side wall 4 covers without gaps the surrounding of the area E, the notch also covers the surrounding of the area E. Furthermore, after the sealing adhesive 9 is cured, an adhesive cured layer that is the cured sealing adhesive 9 is formed. The adhesive cured layer also exists in the notch and covers the surrounding of the area E. As the sealing adhesive 9, for example, silicone adhesives and epoxy adhesives may be used in view of adhesive strength and durability. Silicone adhesives (TSE series) are especially desirable.

The upper plate 5 is a flat plate member which is thinner than the cooler 3. Similarly to the cooler 3, the upper plate 5 is made of metal and has rigidity and ductility higher than general resin materials. The upper plate 5 includes iron, stainless steel, or aluminum as the main component.

Since the outer circumferential side wall 4 covers without gaps the surrounding of the area E, the outer circumferential side wall 4 includes the area E at the interior thereof and can be referred to as a cylindrical member with both ends opened. One opening of the outer circumferential side wall 4 is fixed to the pedestal, and the other opening of the outer circumferential side wall 4 is fixed to the upper plate 5.

The upper plate 5 is fastened to one opening of the outer circumferential side wall 4 by a fastening member 6b such as bolt. The fastening member 6b that fastens the upper plate 5 and the outer circumferential side wall 4 is a second fastening member in claims. Similarly to the contact surface of the pedestal, the notch is formed on the contact surface between the outer circumferential side wall 4 and the upper plate 5. The sealing adhesive 9 is adhered circumferentially around the notch.

By using the fastening member 6a, the fastening member 6b, and the sealing adhesive 9, the pedestal and the outer circumferential side wall 4, and the upper plate 5 and the outer circumferential side wall 4 are joined with air tightness. That is, the space which is surrounded by the pedestal, the outer circumferential side wall 4, and the upper plate 5 and which includes the submodules 1 therein is sealed.

### [1-2. Action and Effect]

According to the above semiconductor device of the present embodiment, the separation of the electrode plate 22a and 22b when the short-circuit failure of the semiconductor chips 21 occurs is prevented, and the destruction of the semiconductor package due to the direct effect from the pressure rise inside the submodule 1 caused by the bursting out of the content in the submodule 1 and the content that has bursted out is prevented. In below, the action and effect from each viewpoint are described.

### (Prevention of Separation of Electrode Plate)

The semiconductor device of the present embodiment includes the reinforcement casing 23. The reinforcement casing 23 becomes an electrode separation prevention member that prevents the separation of the electrode plate 22a and 22b when the short-circuit failure of the semiconductor chips 21 and becomes a burst-out direction regulation member that regulates the burst-out direction of the content in the submodule 1 that bursts out at the time of the failure. For example, when the short-circuit failure occurs at the semiconductor chips 21 for some reason, large current flows into the semiconductor chips 21, and the rupture occurs at the semiconductor chips 21, a load is applied to the upper and lower electrode plates 22 in the direction they may separate by the rupture force produced due to the rupture of the semiconductor chips 21.

As for the separation of the upper and lower electrode plates 22 when the short-circuit failure and the rupture occur at the semiconductor chips 21, the metal reinforcement casing 23 arranged inside the submodule 1 suppresses the separation of the electrode plates 22 by the rigidity thereof. That is, the reinforcement casing 23 is a metal cuboid having the casing open surface at one surface. Among four surfaces standing from edges of a surface (a burst-out direction regulation surface described later) facing the casing open surface 26, two parallel surfaces become the electrode separation prevention member to prevent the electrodes 22 from separating in the vertical direction. That is, by the electrode separation prevention member that sandwiches two electrodes from above and below and side surfaces of the reinforcement casing 23 that fixes the relative position of said electrodes and member, the distance between two electrodes would not change after the occurrence of the short-circuit failure of the semiconductor chips 21. By this, a joining material (solder) near the failed location and the electrodes 22 melt and solidify, so that the conductive state can be maintained.

### (Prevention of Destruction of Semiconductor Chips due to Internal Pressure Rise)

Furthermore, when the rupture occurs at the semiconductor chips 21, a large rupture occurs inside the submodule 1 by melting and gasification of inner components, and the content of the submodule 1 burst out from the submodule 1 by high pressure.

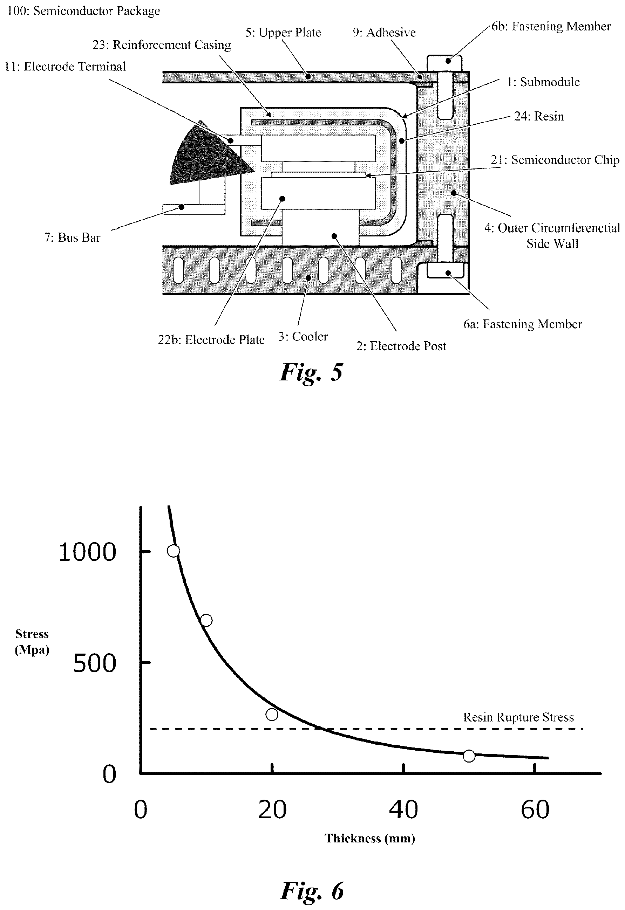

As illustrated in Fig. 5, the content inside the submodule 1 that have become high pressure burst out from the casing open surface 26 of the submodule 1. Fig. 5 is a cross sectional diagram of the submodule illustrating a state in which content thereof bursted out. The burst-out pressure from the submodule 1 would be pressure as high as several ten MPa, and a pressure that makes the pressure inside the semiconductor package to rise to several hundred kPa occurs. To suppress this pressure without the rupture only by the resin casing which has high insulation but made of brittle material, it is required that the upper surface 5 be very thick, resulting in the large-sizing and overweight of the semiconductor package 100.

Fig. 6 derives a relationship between a thickness of the upper plate 5 and a stress when the pressure is applied inside the semiconductor package 1 in a case in which the upper plate 5 is formed of resin in a certain state. From this result, it is found that the thickness of at least 30 to 40 mm or more us needed if the upper plate 5 is formed of resin.

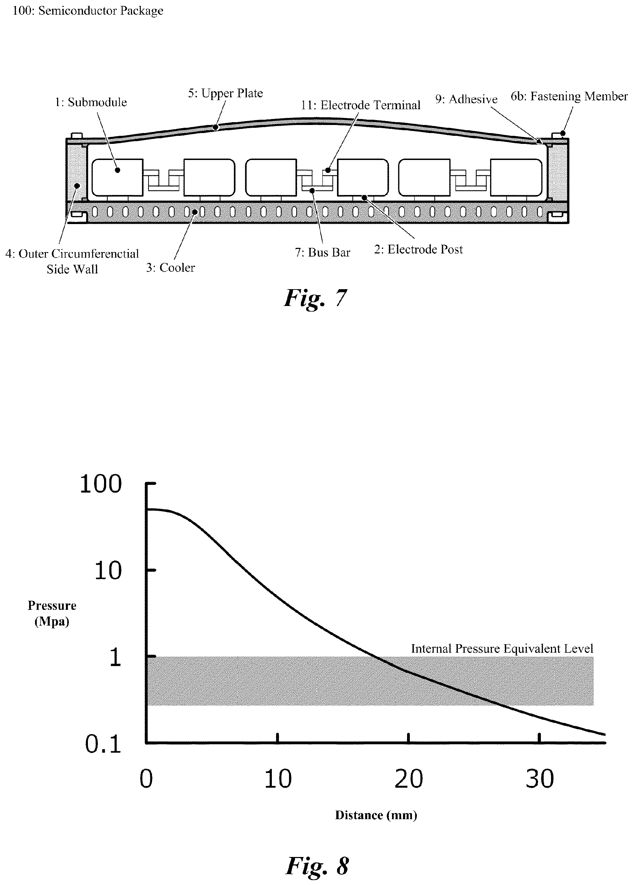

If the upper plate 5 is formed of metal that is a ductile material, such as aluminum, since said material does not rupture and keeps deforming by plastic deformation even after exceeding yield stress, the load can be applied without the rupture. Fig. 7 is a cross sectional diagram of a semiconductor package illustrating a state in which the short-circuit failure occurs inside the semiconductor package 100 and the internal pressure rises.

If the upper plate 5 is formed of metal that is a ductile material, the entire upper plate 5 largely curves and deforms with the end thereof fixed to the fastening member 6 being a fulcrum. Furthermore, since the upper plate 5 receives the load while deforming as described above, the load applied to the fixed portion is mitigated, a conventional mechanism to press with large load is not required. In addition, since large amount of the load is received by the fastening members 6a and 6b, the load applied to the sealing adhesive becomes relatively small. Therefore, by applying the sealing adhesive to the inner side of the fastening members 6a and 6b circumferentially to join the upper plate 5 and the outer circumferential side wall 4, the content inside the semiconductor package is prevented to burst out to the exterior.

### (Prevention of Destruction of Outer Circumferential Side Wall 4 due to Bursted-Out Content)

As illustrated in Fig. 3, by arranging the casing open surface 26 of the submodule to not directly face the outer circumferential side wall 4, high pressure bursted out from the submodule 1 would not directly affect the outer circumferential side wall 4.

The burst-out direction of the content bursted out from the submodule 1 is regulated by the reinforcement casing 23. That is, the direction of the casing open surface 26 would be the burst-out direction. That is, on the mounting plane of the semiconductor chips 21, the surface facing the casing open end 26 of the reinforcement casing 24 (hereinafter, referred to as a burst-out direction regulation surface) is positioned. The burst-out direction regulation surface is the burst-out direction regulation member and regulates the burst-out direction of the content bursted out from the submodule 1. When the semiconductor chips 21 rupture, a part of the content collide the burst-out direction regulation surface, and the burst-out direction thereof changes to the casing open surface 26-side. In addition, by directing the casing open surface 26 away from the outer circumferential side wall 4, the outer circumferential side wall 4 need not to have strength that directly withstand the high-pressure load, and the strength that does not rupture by the internal pressure rise of the semiconductor package 100 would be sufficient.

Fig. 8 is a diagram illustrating a relationship between the pressure applied to the outer circumferential side wall 4 by the content bursted-out from the casing open surface of the submodule 1, and a distance. In this condition, the pressure becomes several hundred kPa at 15 to 25 mm from the burst-out portion, and said pressure would be the same as the internal pressure if the semiconductor package 100 when the semiconductor chips 21 rupture.

Therefore, by ensuring the distance between the outer circumferential side wall 4 and the casing open surface 26 of the submodule 1 to be about 20 mm, the direct action and effect thereto can be mitigated. For example, when one side of the submodule 1 is 30 mm, by arranging other submodule 1 between the outer circumferential side wall 4 and the casing open surface 26, the effect to the outer circumferential side wall 4 by the pressure of the bursted-out content can be suppressed.

As described above, the present embodiment has the effect of excellent operation continuity by preventing the separation of the electrode plate 22a and 22b when the short-circuit failure of the semiconductor chips 21 occurs and the effect of preventing the destruction of the semiconductor package 100 due to the pressure rise inside the submodule 1 caused by the bursting out of the content in the submodule 1 and the content that has bursted out. Each effect affects each other in single or in combination so that the semiconductor package with excellent safety and operation continuity can be achieved.

### [2. Second Embodiment]

### [2-1. Configuration]

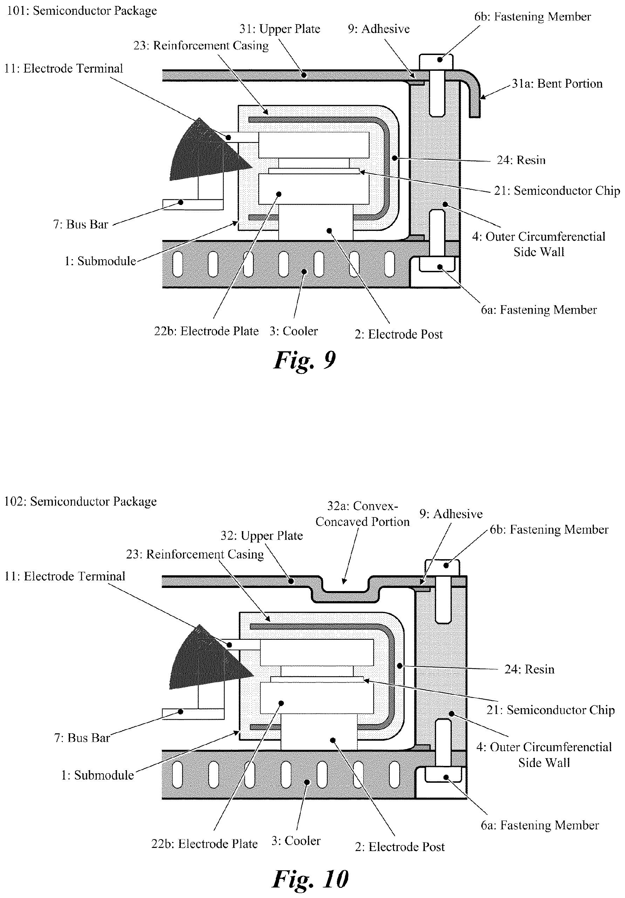

In below, a semiconductor package according to the present embodiment is described with the reference to Fig. 9. Fig. 9 is a partial cross sectional diagram of the semiconductor package 101 according to the second embodiment.

In the present example, an upper plate 31 in which an end thereof is bent is arranged instead of the upper plate 5. By providing a bent portion 31a at the end of the upper plate 31, the upper plate 31 has the rib effect to suppress the deformation when the upper plate deforms by the internal pressure rise of the semiconductor package 101.

### [2-2. Action and Effect]

When the content burst out by the pressure when the semiconductor chips 21 rupture, since it is caused by gap produced at the joined portion of the outer circumferential side wall 4 and the upper plate 31, by improving the flexural rigidity near the joined portion like the present example, the burst out of the content can be suppressed.

To achieve similar effect, as illustrated in Fig. 10, by providing a convex-concaved portion 32a at the inner side of the outer circumferential side wall 4 of the upper plate 32 instead of providing the bent portion at the end of the upper plate, the flexural rigidity of the entire upper plate 32 is improved, and the expansion deformation due to the internal pressure rise inside the semiconductor package 32 can be suppressed. Even by such configuration, the effect of suppressing the gap at the joined portion of the upper plate 32 and the outer circumferential side wall 4 can be obtained, and the burst out of the content can be suppressed more easily.

### [3. Third Embodiment]

### [3-1. Configuration]

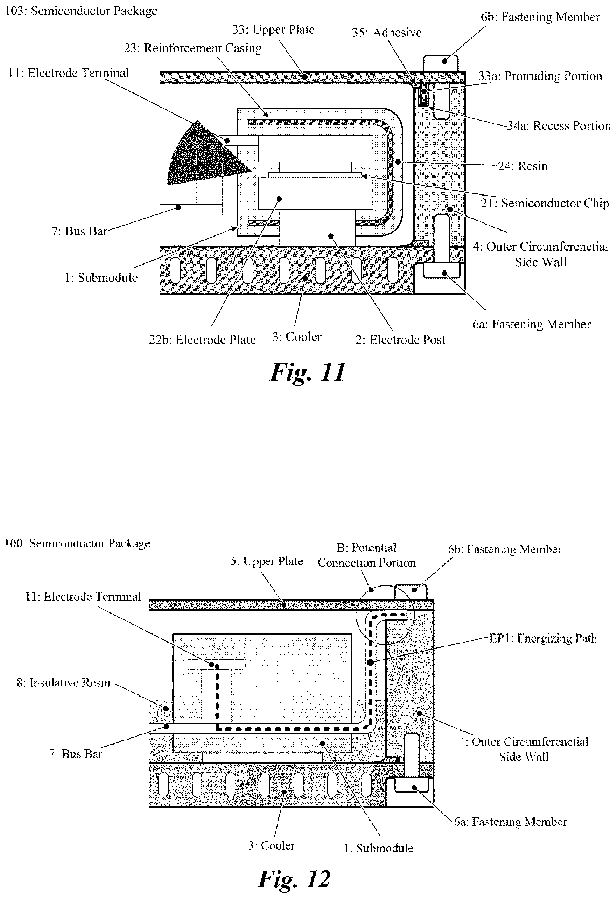

In below, a semiconductor package according to the present embodiment is described with the reference to Fig. 11. Fig. 9 is a partial cross sectional diagram of the semiconductor package 103 according to the third embodiment.

In the present example, an upper plate 33 having a protruding portion 33a at an adhesive applied portion 33a at the end instead of the upper plate 5. Furthermore, a recess portion 34a which fits the protruding portion 33a is provided on the upper plate joining portion to form a labyrinth structure by the protruding portion 33a and the recess portion 34a. In addition, a sealing adhesive 35 is filled to fill a gap formed between an upper plate protruding portion 33a and an outer circumferential side wall recess portion 34a.

### [3-2. Action and Effect]

By such configuration, since the upper plate protruding portion 33a obtains the rib effect relative to the flexural deformation, the flexural rigidity is improved, and since the deformation of the upper plate 33 is suppressed, the gap between the upper plate 33 and the outer circumferential side wall 4 can be suppressed from being produced.

Furthermore, even if the upper plate 24 is deformed and the gap is likely to be formed between the upper plate 34 and the outer circumferential side wall 4, since the labyrinth structure is formed by the protruding portion 33a and the recess portion 34a and the adhesive 35 is filled in the gap therebetween, the content is prevented from bursting out to the exterior of the semiconductor package 100 as long as the deformation does not become so large that the protruding portion 33a come out from the recess portion 34a.

### [4. Other Embodiment]

As above, although some embodiments of the present disclosure are described, these embodiments are merely provided as examples and are not intended to limit the scope of claims. These new embodiments can be implemented in other various forms, and various omissions, replacements, and modifications can be made without departing from the abstract of claims. These embodiments and modifications thereof are included in the scope and abstract of the present embodiment, and is included in the invention described in the scope of claim and equivalent range thereto.

Furthermore, structures in which potentials of the upper plate 5, the upper plate 31, the upper plate 32, and the upper plate 33 described in the first to third embodiment is equivalent to potential at one side of the semiconductor chips 21 may be employed.

Fig. 12 is a cross sectional diagram illustrating one example according to the present embodiment. In Fig. 12, the electrode plate 22b is connected to an emitter of the semiconductor chips 21. The upper plate 5 is electrically connected to the bus bar 7 at a potential connection portion B. The upper plat 5 has the potential equivalent with an energizing path EP1 which include the electrode plate 22b and the bus bar 7.

By this, the upper plate would not be independent from the energizing path EP1 including the electrode plate 22b and the bus bar 7, and the energizing path EP2 via the electrode plate 22b, the electrode post 212, an the cooler 32. For example, if the upper plate 5 is not included in other energizing circuit, some potential may be produced by the effect of the surrounding environment. If large potential is produced, unexpected discharging may occur, which is a problem in view of safety.

Accordingly, to control the potential of the upper plate 5, the upper plate 5 is connected to either of the energizing path EP1 and EP2 at the ground side. By this, the semiconductor package 100 in which the potential of the upper plate 5 is controlled can be achieved.

### REFERENCE SIGN

100: semiconductor package
101: semiconductor package
102: semiconductor package
103: semiconductor package
1: submodule
2: electrode post
3: cooler
4: outer circumferential side wall
5: upper plate
6: fastening member
7: bus bar
8: insulative resin
11: electrode terminal
21: semiconductor chip
22: electrode plate
23: reinforcement casing
25: gate connector
26: casing open surface
31: upper plate
31a: bent portion
32: upper plate
32a: convex-concaved portion
33: upper plate
33a: protruding portion
33a: upper plate protruding portion
34: upper plate
34a: recess portion
34: outer circumference side wall
34a: outer circumference side wall recess portion
35: sealing adhesive

## Claims

1. A semiconductor package including therein a plurality of submodules which has semiconductor chips therein and which is electrically connected in parallel, the semiconductor package comprising:
an electrode post which is in pair with the submodule and which supports the submodule;
a pedestal which is made of metal flat plate and which fixes the electrode post on one of surfaces thereof;
an outer circumferential side wall which is made of resin, which stands up from the pedestal and which surrounds a circumference of the plurality of the submodules;
an upper plate which is made of metal and which blocks an opening formed by the outer circumferential side wall;
a first fastening member which fixes the pedestal and the outer circumferential side wall by fastening; and
a second fastening member which fixes the upper plate and the outer circumferential side wall by fastening,
wherein the pedestal, the outer circumferential side wall, and the upper plate seals a space which includes therein the plurality of the submodules.

2. The semiconductor package according to claim 1, wherein at least one of the pedestal and the outer circumferential side wall, and the upper plate and the outer circumferential side wall is adhered by an adhesive together with fastening by the fastening member.

3. The semiconductor package according to claim 2, wherein:
the outer circumferential side wall comprises a notch which is formed by cutting out a part of a contact surface of the outer circumferential side wall 4 in contact with the pedestal or the upper plate, and
an adhesive cured layer formed by the cured adhesive is formed in the notch.

4. The semiconductor package according to any one of claims 1 to 3, wherein in the submodule, in a mounting plane of the semiconductor chips, a burst-out direction regulation member which is made of metal is arranged at least on an extending plane which is radially extended from a center of the semiconductor chip.

5. The semiconductor package according to claim 4, wherein:
the submodule comprises:
two electrode which is in parallel with the mounting plane of the semiconductor chips and which are arranged above and below the semiconductor chips; and
an electrode separation prevention member which has two metal plate arranged to sandwich the two electrodes, and
the burst-out direction regulation member is one of the electrode separation prevention member and fixes two metal plates that are the electrode separation prevention members at a relative position.

6. The semiconductor package according to claim 5, wherein:
the electrode separation prevention member is a metal cuboid having an open surface which is one surface opened,
the burst-out direction regulation member is one surface of the cuboid facing the opened surface, and
the two metal plates are plates that form two surfaces in parallel among four surface standing up from the one surface of the cuboid that is the burst-out direction regulation member.

7. The semiconductor package according to any one of claims 1 to 6, wherein:
in the mounting plane of the semiconductor chips,
the opened surface which does not have a metal member is provided at least a part of the extending plane which is radially extended from the center of the semiconductor chip, and
other submodules are arranged in between the opened surface and the outer circumferential side wall.

8. The semiconductor package according to any one of claims 1 to 7, wherein an end or a part of an interior of at least one of the upper plate and the pedestal comprises a bent portion which bent.

9. The semiconductor package according to any one of claims 1 to 8, wherein an end or a part of an interior of at least one of the upper plate and the pedestal comprises a protruding portion.

10. The semiconductor package according to claim 9, wherein a recess portion which fits with the protruding portion is formed on at least one of a contact surface of the upper surface and the outer circumferential side wall, and a contact surface of the pedestal and the outer circumferential side wall.

11. The semiconductor package according to claim 10, wherein the adhesive cured layer is formed inside the recess portion when the protruding portion is inserted into the recess portion.

## Amended claims

### Amended claims under Art. 19.1 PCT

1. A semiconductor package including therein a plurality of submodules which has semiconductor chips therein and which is electrically connected in parallel, the semiconductor package comprising:
an electrode post which is in pair with the submodule and which supports the submodule;
a pedestal which is made of metal flat plate and which fixes the electrode post on one of surfaces thereof;
an outer circumferential side wall which is made of resin, which stands up from the pedestal and which surrounds a circumference of the plurality of the submodules;
an upper plate which is made of metal and which blocks an opening formed by the outer circumferential side wall;
a first fastening member which fixes the pedestal and the outer circumferential side wall by fastening; and
a second fastening member which fixes the upper plate and the outer circumferential side wall by fastening,
wherein :
-the pedestal, the outer circumferential side wall, and the upper plate seals a space which includes therein the plurality of the submodules, and
in the submodule, in a mounting plane of the semiconductor chips, a burst-out direction regulation. member which is made of metal is arranged at least on an extending plane which is radially extended from a center of the semiconductor chip.

2. The semiconductor package according to claim 1, wherein at least one of the pedestal and the outer circumferential side wall, and the upper plate and the outer circumferential side wall is adhered by an adhesive together with fastening by the fastening member.

3. The semiconductor package according to claim 2, wherein:
the outer circumferential side wall comprises a notch which is formed by cutting out a part of a contact surface of the outer circumferential side wall 4 in contact with the pedestal or the upper plate, and
an adhesive cured layer formed by the cured adhesive is formed in the notch.

4. The semiconductor package according to claim 41, wherein:
the submodule comprises:
two electrode which is in parallel with the mounting plane of the semiconductor chips and which are arranged above and below the semiconductor chip; and
an electrode separation prevention member which has two metal plate arranged to sandwich the two electrodes, and
the burst-out direction regulation member is one of the electrode separation prevention member and fixes two metal plates that are the electrode separation prevention members at a relative position.

5. The semiconductor package according to claim 4, wherein:
the electrode separation prevention member is a metal cuboid having an open surface which is one surface opened,
the burst-out direction regulation member is one surface of the cuboid facing the opened surface, and
the two metal plates are plates that form two surfaces in parallel among four surface standing up from the one surface of the cuboid that is the burst-out direction regulation member.

6. The semiconductor package according to any one of claims 1 to 5, wherein:
in the mounting plane of the semiconductor chips,
the opened surface which does not have a metal member is provided at least a part of the extending plane which is radially extended from the center of the semiconductor chip, and
other submodules are arranged in between the opened surface and the outer circumferential side wall.

7. The semiconductor package according to any one of claims 1 to 6, wherein an end or a part of an interior of at least one of the upper plate and the pedestal comprises a bent portion which bent.

8. The semiconductor package according to any one of claims 1 to 7, wherein an end or a part of an interior of at least one of the upper plate and the pedestal comprises a protruding portion.

9. The semiconductor package according to claim 8, wherein a recess portion which fits with the protruding portion is formed on at least one of a contact surface of the upper surface and the outer circumferential side wall, and a contact surface of the pedestal and the outer circumferential side wall.

10. The semiconductor package according to claim 9, wherein the adhesive cured layer is formed inside the recess portion when the protruding portion is inserted into the recess portion.
